# EUROPÄISCHE PATENTSCHRIFT

(11) **EP 0 590 512 B1**
(45) Veröffentlichungstag und Bekanntmachung des Hinweises auf die Patenterteilung: **25.10.1995**
(21) Anmeldenummer: 93115319.1
(22) Anmeldetag: 23.09.1993
(51) Int. Cl.: H05K 3/34, H05K 1/18, B23K 3/08

(54) **Verfahren zum Anlöten eines thermisch empfindlichen Bauteils, wie eines Displays, an einer Leiterplatte**
Method of soldering a heat sensitive component, e.g a display, to a printed circuit board
Méthode pour souder un composant sensible à la chaleur, p.e. un display, à une plaquette de circuit imprimé

(30) Priorität: 29.09.1992 DE 4232600
(43) Veröffentlichungstag der Anmeldung: 06.04.1994
(73) Patentinhaber: Eaton GmbH, D-78559 Gosheim (DE)
(72) Erfinder: Anders, Klaus, D-78559 Gosheim (DE)
(74) Vertreter: Vetter, Hans, Dipl.-Phys. Dr.

(56) Entgegenhaltungen:
- FR-A- 2 571 920

## Beschreibung

Die Erfindung betrifft ein Verfahren zum Anlöten eines thermisch empfindlichen Bauteils, wie eines Displays, an einer Leiterplatte, wobei dieses Bauteil an einer Seite der Leiterplatte und andere elektrische Bauteile an der gegenüberliegenden Seite der Leiterplatte anzuordnen sind, und das Anlöten der anderen elektrischen Bauteile mittels einer Lötstrecke durch Vorbeiführen der horizontal in einem Lötrahmen befestigten Leiterplatte an einer Lötwelle erfolgt, wie in Anspruch 1 offenbart.

Bei einem aus der EP-A-147 000 bekannten Lötverfahren wird eine zu bestückende Leiterplatte in horizontaler Position befestigt. Die Anschlußdrähte der anzulötenden Bauteile, wie Transistoren, Dioden, Widerstände, Kondensatoren und dergleichen, werden in entsprechende Bohrungen der Leiterplatte gesteckt, insbesondere mittels eines Bestückungsautomaten. Danach wird die Leiterplatte an einer aus flüssigem Lot bestehenden Lötwelle vorbeigeführt, so daß die Unterseite der Leiterplatte benützt wird und die Anschlußdrähte an die entsprechenden Leiterbahnen gelötet werden.

Soll ein Display, beispielsweise eine Vacuumfluorescenzanzeige ebenfalls an der Leiterplatte angelötet werden, so ist es aus Platzgründen häufig erforderlich, daß das Display auf der den übrigen Bauteilen gegenüberliegenden Seite der Leiterplatte angeordnet werden muß. An dieser Stelle wäre es jedoch beim automatischen Lötvorgang der heißen Lötwelle ausgesetzt, was bei derartigen thermisch empfindlichen Displays zu einer Zerstörung führen würde. Wie dies z. B. aus der FR-A-2 571 920 hervorgeht, wird daher das Display zunächst mit sehr langen Anschlußdrähten auf der Seite der übrigen Bauteile angeordnet, d. h. die Anschlußdrähte werden durch entsprechende Bohrungen der Leiterplatte hindurchgesteckt und der zuvor beschriebene Lötvorgang durchgeführt. Danach muß das Display mit den sehr langen Anschlußdrähten um die benachbarte Kante der Leiterplatte herumgebogen werden, damit das Display auf der den Bauteilen gegenüberliegenden Seite positioniert wird.

Der Nachteil des bekannten Verfahrens besteht darin, daß die sehr langen Anschlußdrähte mechanisch sehr leicht in ihrer Position verändert werden können und auch sehr schlecht ausrichtbar sind, so daß ein Einführen durch die Vielzahl von Leiterplattenbohrungen nur sehr schwer und umständlich durchführbar ist und ein vollautomatisches Verfahren daher nahezu ausscheidet. Durch das Umbiegen dieser Anschlußdrähte um die benachbarte Leiterplattenkante ist ein weiterer Verfahrensschritt erforderlich, die wiederum eine relativ komplizierte Handhabungstechnik erfordert. Darüber hinaus wirken sich die um die Kante herumgebogenen Anschlußdrähte häufig als störend aus und sind Anlaß zu Kurzschlüssen und Fehlfunktionen.

Eine Aufgabe der vorliegenden Erfindung besteht daher darin, derartige thermisch empfindliche Bauteile in einem mehrfach zu automatisierenden Verfahren so an einer Leiterplatte anzulöten, daß sie auf der den übrigen Bauteilen gegenüberliegenden Seite der Leiterplatte positioniert sind.

Diese Aufgabe wird erfindungsgemäß dadurch gelöst, daß in einem weiteren Schritt die Leiterplatte senkrecht auf dem Lötrahmen angeordnet wird, wobei die Lötanschlüsse des thermisch empfindlichen Bauteils in tangentialer Anlage mit im unteren randseitigen Bereich der Leiterplatte angeordneten Lötflächen der Leiterplatte gehalten werden, und daß der Lötrahmen an einer diese Lötflächen überstreichenden Lötwelle vorbeigeführt wird, wobei zum thermischen Schutz eine Maske unterhalb des thermisch empfindlichen Bauteils angeordnet wird, durch die der untere Bereich der Leiterplatte mit den Lötflächen sowie die Lötanschlüsse des thermisch empfindlichen Bauteils hindurchreichen, wie in Anspruch 1 offenbart.

Beim erfindungsgemäßen Verfahren können somit die übrigen Bauteile zunächst in der üblichen Weise verlötet werden. Dann muß die Leiterplatte lediglich in eine vertikale Position gebracht werden, wobei die Lötanschlüsse des thermisch empfindlichen Bauteils, beispielsweise eines Displays, an den entsprechenden Lötflächen anliegen. Beim Vorbeiführen an einer weiteren Lötwelle oder beim nochmaligen Vorbeiführen an der ersten Lötwelle wird dann lediglich der randseitige Bereich mit diesen Lötanschlüssen des Displays gelötet, während die übrigen Lötstellen nicht mehr in Kontakt mit der Lötwelle gelangen. Es muß also lediglich eine Vorrichtung zum vertikalen Aufrichten der Leiterplatte und zum Anlegen der Lötanschlüsse des thermisch empfindlichen Bauteils vorgesehen werden, so daß die gesamten Lötvorgänge in zwei Schritten in einem Verfahren durchgeführt werden können. Ein Durchstecken von Lötanschlüssen des thermisch empfindlichen Bauteils ist nicht mehr erforderlich, und die Ränder der Leiterplatte sind von allen Seiten frei zugänglich. Durch die Maske wird verhindert, daß die Lötwelle in Kontakt mit dem thermisch empfindlichen Bauteil selbst gelangen kann.

Durch die in den Unteransprüchen aufgeführten Maßnahmen sind vorteilhafte Weiterbildungen und Verbesserungen des im Anspruch 1 angegebenen Verfahrens möglich.

Die Drehung der Leiterplatte um im wesentlichen 90° auf dem Lötrahmen erfolgt in vorteilhafter Weise automatisch entweder durch eine schwenkbare Aufnahme am Lötrahmen oder durch Umstecken von der waagrechten Aufnahme in die senkrechte Aufnahme, beispielsweise durch einen Roboterarm. Dieses Umstecken kann selbstverständlich auch manuell durchgeführt werden.

Das thermisch empfindliche Bauteil wird zweckmäßigerweise ebenfalls in eine entsprechende, seine Lötanschlüsse in die tangentiale Anlage an die Lötflächen der Leiterplatte haltende Halterung eingesetzt, um die mechanische Zuordnung zwischen Bauteil und Leiterplatte zu gewährleisten. Diese Halterung kann an der Leiterplatte oder am Lötrahmen angeordnet sein.

Das als Display ausgebildete Bauteil wird im wesentlichen parallel zur Leiterplatte angeordnet, wobei die Lötanschlüsse zuvor zur Anlage an die Lötflächen der Leiterplatte im wesentlichen S-förmig vorgerichtet wurden. Das Display kann entweder mit derart vorgerichteten Lötanschlüssen bezogen werden oder das Vorrichten erfolgt in einem gesonderten Arbeitsgang.

Zur Erläuterung des Verfahrens ist eine auf einem Lötrahmen angeordnete Leiterplatte in der Zeichnung dargestellt und in der nachfolgenden Beschreibung näher erläutert. Es zeigen:
- Figur 1: eine vertikal auf einem Lötrahmen angeordnete Leiterplatte in einer Ansicht auf die Schmalseite und
- Figur 2: eine um 90° versetzte Seitenansicht auf eine Breitseite der Leiterplatte.

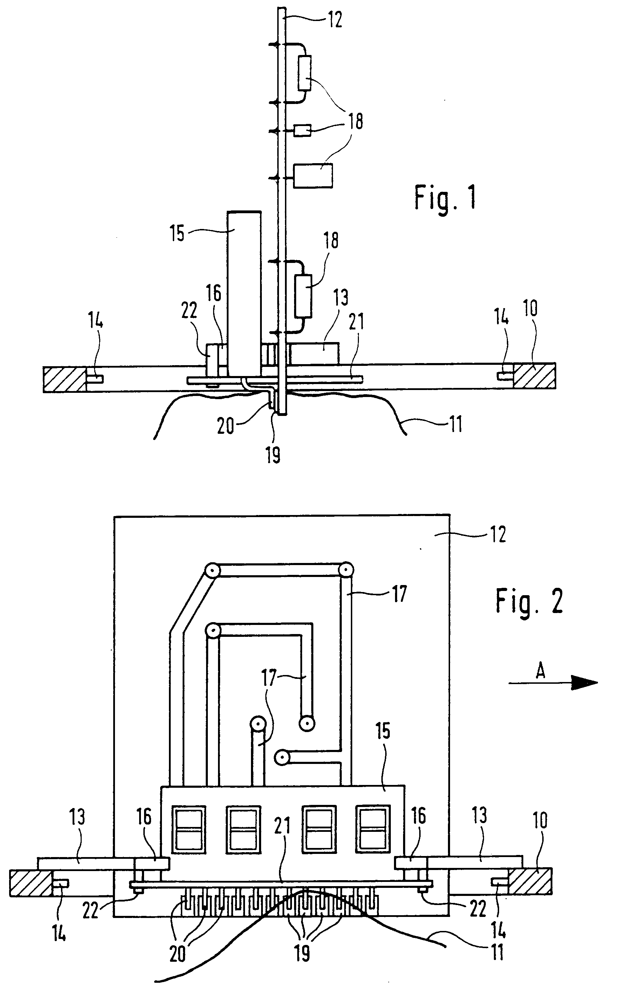

Die in den Figuren 1 und 2 in verschiedenen Seitenansichten dargestellte Anordnung weist einen an sich bekannten Lötrahmen 10 auf, der in nicht näher dargestellter Weise an einer Lötstrecke in waagrechter Position vorbeigeführt wird, wobei von unten her eine Lötwelle 11 aus flüssigem Lot in Kontakt mit den zu lötenden Stellen einer Leiterplatte 12 gelangt. Die Bewegungsrichtung des Lötrahmens 10 verläuft gemäß Fig. 1 in die Bildebene hinein, während die Bewegungsrichtung in Fig. 2 durch einen Pfeil A gekennzeichnet ist.

Der Lötrahmen 10 besitzt einen nur schematisch dargestellte Halterung 13 zur vertikalen Positionierung der Leiterplatte 12. Weiterhin ist eine Halterung 14 zur horizontalen Positionierung 10 dieser Leiterplatte 12 vorgesehen.

Zur Positionierung eines Vacuumfluorescenzdisplays 15 parallel zur vertikalpositionierten Leiterplatte 12 ist eine weitere Halterung 16 vorgesehen, die an der Halterung 13 für die Leiterplatte 12 angeordnet ist. Prinzipiell könnte diese Halterung 16 auch an der Leiterplatte 12 oder direkt am Lötrahmen 10 angebracht sein.

Auf der Leiterplatte 12 sind in bekannter Weise Leiterbahnen 17 angeordnet, die im dargestellten Ausführungsbeispiel eine bestimmte Konfiguration bilden, die selbstverständlich sehr großen Variationen unterliegt. Diese Leiterbahnen 17 stellen Verbindungsleitungen zwischen elektrischen und elektronischen Bauteilen 18 dar, deren Anschlußdrähte durch Bohrungen in der Leiterplatte 12 an Anschlußstellen der Leiterbahnen 17 hindurchgesteckt und mit diesen Leiterbahnen 17 verlötet sind bzw. verlötet werden. Diese elektrischen Bauteile 18 befinden sich an einer Seite der Platte 12, während sich das Vacuumfluoresvcenzdisplay 15 an der gegenüberliegenden Seite befindet. Die Leiterbahnen 17 münden zum Anschluß des Vacuumfluorescenzdisplays 15 an Lötflächen 19, die sich am unteren Randbereich der Leiterplatte 12 befinden. Eine entsprechende Anzahl von als Anschlußdrähte ausgebildeten Lötanschlüssen 20 des Vacuumfluorescenzdisplays 15 sind S-förmig zur Leiterplatte 12 hin gebogen, wobei die Halterung 16 relativ zur Halterung 13 so angeordnet ist, daß die Enden dieser Lötanschlüsse 20 tangential an den Lötflächen 19 anliegen.

Unterhalb des Vacuumfluorescenzdisplays ist eine Schutzmaske 21 zum thermischen Schutz des Vacuumfluorescenzdisplays 15 an Halterungen 22 gehalten, die ihrererseits an der Halterung 16 befestigt sind. Diese Halterung 22 kann ebenfalls an anderen Stellen desLötrahmens 10 oder der Leiterplatte 12 befestigt sein. Die Lötanschlüsse 20 und der untere Bereich der Leiterplatte 12 mit den Lötflächen 19 reichen durch diese Halterung 22 hindurch.

Für das erfindungsgemäße Lötverfahren wird zunächst die Leiterplatte 12 horizontal in den Lötrahmen 10 eingelegt, wo sie durch die Halterungen 14 gehalten wird. Danach werden die elektrischen Bauteile 18 in entsprechende Bohrungen der Leiterplatte angesetzt, beispielsweise durch einen Bestückungsautomaten. Danach wird der Lötrahmen 10 mit der bestückten Leiterplatte 12 an einer Lötwelle 11 vorbeibewegt, durch die die durch die Leiterplatte 12 hindurchragenden Anschlußdrähte und die damit in Kontakt stehenden Leiterbahnen benetzt und miteinander verlötet werden. Danach wird die Leiterplatte 12 in die in den Fig. 1 und 2 dargestellte vertikale Position gebracht, wo sie durch die Halterung 13 gehalten wird. Auch das Vacuumfluorescenzdisplay 15 wird in die entsprechende vertikale Position gebracht, in der seine Lötanschlüsse 20 an den Lötflächen 19 anliegen. Nun wird der Lötrahmen 10 erneut entlang einer nicht näher dargestellten Lötstrecke bewegt, wobei die Lötanschlüsse 20 und die Lötflächen 19 von einer Lötwelle 11 benetzt und verlötet werden. Die Schutzmaske 21 schützt das Vaccumfluorescenzdisplay 15 und die übrigen Bauteile 18 gegen thermische Einwirkungen der Lötwelle 11.

Die Durchführung des erfindungsgemäßen Verfahrens kann in einem Arbeitsvorgang erfolgen, bei dem der Lötrahmen 10 nacheinander jeweils einer Lötwelle 11 ausgesetzt wird und wobei dazwischen das Umsetzen der Leiterplatte 12 von der horizontalen in die vertikale Position erfolgt. Das Umsetzen kann manuell oder beispielsweise mittels eines Roboterarms erfolgen. Es ist auch möglich, im Lötrahmen 10 eine schwenkbare Halterung für die Leiterplatte 12 vorzusehen, durch die die Leiterplatte 12 nach dem ersten Lötvorgang automatisch in die vertikale Lage geschwenkt wird. Das Hinzufügen des Vacuumfluorescenzdisplays 15 kann ebenfalls mittels eines Roboterarms bzw. eines Bestückungsautomaten erfolgen.

Das erfindungsgemäße Verfahren eignet sich selbstverständlich auch für andere thermisch empfindliche Bauteile, die an einer Seite der Leiterplatte gegenüber den übrigen Bauteilen angeordnet werden sollen , und bei denen ein handseitiger elektrischer Anschluß möglich ist. Dieses Verfahren läßt sich noch dadurch erweitern, daß auch an den übrigen Seiten der Leiterplatte noch nachträglich elektrische Bauteile in derselben Weise angelötet werden, wie dies beim Vacuumfluorescenzdisplay 15 der Fall war.

## Patentansprüche

1. Verfahren zum Anlöten eines thermisch empfindlichen Bauteils (15), wie eines Displays, an einer Leiterplatte (12), dieses Bauteil an einer Seite der Leiterplatte und andere elektrische Bauteile (18) an der gegenüberliegenden Seite der Leiterplatte anzuordnen sind und das Anlöten der anderen elektrischen Bauteile mittels einer Lötstrecke und Vorbeiführen der horizontal in einem Lötrahmen (10) befestigten Leiterplatte (12) an einer Lötwelle (11) erfolgt, in einem weiteren Schritt die Leiterplatte (12) senkrecht auf dem Lötrahmen (10) angeordnet wird, wobei die Lötanschlüsse (20) des thermisch empfindlichen Bauteils (15) in tangentialer Anlage mit im unteren randseitigen Bereich der Leiterplatte (12) angeordneten Lötflächen (19) gehalten werden, und der Lötrahmen (10) an eine diese Lötflächen (19) überstreichenden Lötwelle (11) vorbeigeführt wird, wobei zum thermischen Schutz eine Maske (21) unterhalb des thermisch empfindlichen Bauteils (15) angeordnet wird, durch die der untere Bereich der Leiterplatte (12) mit den Lötflächen (19) sowie die Lötanschlüsse (20) des thermisch empfindlichen Bauteils (15) hindurchreichen.

2. Verfahren nach Anspruch 1, dadurch gekennzeichnet, daß die Drehung der Leiterplatte (12) um im wesentlichen 90° auf dem Lötrahmen (10) automatisch durchgeführt wird.

3. Verfahren nach Anspruch 1 oder 2, dadurch gekennzeichnet, daß zur Drehung der Leiterplatte (12) diese von einer ersten waagrechten Aufnahme (14) in eine zweite senkrechte Aufnahme (13) umgesteckt wird.

4. Verfahren nach Anspruch 1 oder 2, dadurch gekennzeichnet, daß eine um im wesentlichen 90° schwenkbare Aufnahme für die Leiterplatte (12) am Lötrahmen (10) vorgesehen ist.

5. Verfahren nach einem der vorhergehenden Ansprüche, dadurch gekennzeichnet, daß das thermisch empfindliche Bauteil (15) ebenfalls in eine entsprechend, seine Lötanschlüsse (20) in tangentiale Anlage an den Lötflächen (19) der Leiterplatte (12) haltende Halterung (16) eingesetzt wird.

6. Verfahren nach einem der vorhergehenden Ansprüche, dadurch gekennzeichnet, daß das als Display ausgebildete Bauteil (15) im wesentlichen parallel zur Leiterplatte (12) angeordnet wird, wobei die Lötanschlüsse (20) zuvor zur Anlage an die Lötflächen (19) der Leiterplatte (12) im wesentlichen S-förmig vorgerichtet werden.

## Claims

1. Method of soldering a thermally-sensitive component (15), such as a display, to a printed circuit board (12), wherein this component is to be mounted on one side of the printed circuit board and other electrical components (18) on the other side of the printed circuit board, and soldering of the other electrical components is effected by means of a soldering length and guiding through at a solder wave (11) the printed circuit board (12) fixed in a soldering frame (10), while in a further stage the printed circuit board (12) is mounted vertically on the soldering frame (10), whereby the soldered connections (20) of the thermally-sensitive component (15) are held in tangential contact with solder surfaces (19) in the lower boundary zone of the printed circuit board (12), and the soldering frame (10) is guided past a solder wave (11) covering these soldered surfaces (19), while for thermal protection a mask (21) is arranged beneath the thermally-sensitive component, through which pass the bottom section of the printed circuit board (12) with the soldered surfaces (19) together with the soldered connections (20) of the thermally-sensitive component.

2. Method according to claim 1, characterized in that rotation of the printed circuit board (12) on the soldering frame (10) by essentially 90° is carried out automatically.

3. Method according to claim 1 or 2, characterized in that, to rotate the printed circuit board (12), the latter is moved from a first horizontal mounting (14) to a second vertical mounting (13).

4. Method according to claim 1 or 2, characterized in that a mounting for the printed circuit board (12) capable of rotating through essentially 90° is provided on the soldering frame (10).

5. Method according to any of the preceding claims, characterized in that the thermally-sensitive component (15) is likewise inserted in a corresponding mounting (16) which holds its soldered connections (20) in tangential contact with the solder surfaces (19) of the printed circuit board (12).

6. Method according to any of the preceding claims, characterized in that the component in the form of a display is mounted essentially parallel to the printed circuit board (12), with the soldered connections (20) first being aligned in front in an S-shape for contact with the solder surfaces (19) of the printed circuit board (12).

## Revendications

1. Procédé de brasage sur une plaquette imprimée (12) d'un composant thermosensible (15) tel qu'une unité d'affichage, ce composant devant être disposé sur un côté de la plaquette imprimée et d'autres composants électriques sur le côté opposé de la plaquette imprimée, et le brasage des autres composants électriques s'effectuant au moyen d'un parcours de brasage et de l'amenée devant un arbre de brasage (11) de la plaquette imprimée (12) fixée horizontalement dans un cadre de brasage (10), la plaquette imprimée (12) étant disposée verticalement sur le cadre de brasage (10) lors d'une étape suivante, les connexions à braser (20) du composant thermosensible (15) étant maintenues en application tangentielle avec des surfaces de brasage (19) disposées dans la région de bord inférieur de la plaquette imprimée (12), et le cadre de brasage (10) étant amené devant un arbre de brasage (11) balayant ces surfaces de brasage (19), un masque (21) étant disposé aux fins de protection thermique en dessous du composant thermosensible (15), masque à travers lequel s'étendent la région inférieure de la plaquette imprimée (12) pourvue des surfaces de brasage (19) ainsi que les connexions à braser (20) du composant thermosensible (15).

2. Procédé selon la revendication 1, caractérisé en ce que la rotation de la plaquette imprimée (12) d'environ 90° sur le cadre de brasage (10) est réalisée de façon automatique.

3. Procédé selon la revendication 1 ou 2, caractérisé en ce que, pour la rotation de la plaquette imprimée (12), cette dernière est transférée d'un premier réceptacle horizontal (14) dans un deuxième réceptacle vertical (13).

4. Procédé selon la revendication 1 ou 2, caractérisé en ce qu'un réceptacle pouvant pivoter d'environ 90° est prévu pour la plaquette imprimée (12) sur le cadre de brasage (10).

5. Procédé selon l'une quelconque des revendications précédentes, caractérisé en ce que le composant thermosensible (15) est lui aussi installé dans un support correspondant (16), maintenant ses connexions à braser (20) en application tangentielle contre les surfaces de brasage (19) de la plaquette imprimée (12).

6. Procédé selon l'une quelconque des revendications précédentes, caractérisé en ce que le composant (15) se présentant sous la forme d'une unité d'affichage est disposé sensiblement parallèlement à la plaquette imprimée (12), les connexions à braser (20) étant apprêtées sensiblement en forme de S préalablement à leur application contre les surfaces de brasage (19) de la plaquette imprimée (12).
